(19) **Europäisches Patentamt / European Patent Office / Office européen des brevets**

(11) **EP 1 217 659 B1**

(12) **EUROPÄISCHE PATENTSCHRIFT**

(45) Veröffentlichungstag und Bekanntmachung des Hinweises auf die Patenterteilung:
**25.05.2011 Patentblatt 2011/21**

(51) Int Cl.:
*H01L 23/13* (2006.01)     *H01L 23/538* (2006.01)
*H01L 23/373* (2006.01)

(21) Anmeldenummer: **01129819.7**

(22) Anmeldetag: **14.12.2001**

(54) **Leistungshalbleitermodul mit hoher Spannungsfestigkeit**

Power Semiconductor Modul with an High Withstanding against Voltage

Module à semi-conducteur avec avec tension de claquage élevée

(84) Benannte Vertragsstaaten:
**AT BE CH CY DE DK ES FI FR GB GR IE IT LI LU MC NL PT SE TR**

(30) Priorität: **20.12.2000 DE 10063714**
**27.11.2001 DE 10158185**

(43) Veröffentlichungstag der Anmeldung:
**26.06.2002 Patentblatt 2002/26**

(73) Patentinhaber: **SEMIKRON Elektronik GmbH & Co. KG**
**90431 Nürnberg (DE)**

(72) Erfinder: **Scheuermann, Uwe, Dr.**
**90439 Nürnberg (DE)**

(56) Entgegenhaltungen:
**EP-A- 0 827 198      EP-A- 0 874 399**
**EP-A2- 0 789 397      EP-A2- 1 107 310**
**WO-A2-00/08686**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Leistungshalbleitermodul bestehend aus einem beidseitig metallkaschierten keramischen Substrat, mindestens einem Halbleiterbauelement, zur Kontaktierung benötigten Anschlüssen sowie einem Gehäuse. Derartige Leistungshalbleitermodule mit oder ohne Grundplatte bieten gegenüber diskreten Leistungsschaltern (z.B. Scheibenzellen, TO220) den großen Vorteil der inneren Isolierung gegenüber der Wärmesenke. Diese innere Isolierung wird durch den Einsatz von beidseitig metallkaschierten keramischen Substraten erreicht, die eine hohe Isolationsfestigkeit mit einer großen Wärmeleitfähigkeit verbinden. Sie erlauben den effizienten Aufbau von Leistungsschaltungen, da sie neben der Basisisolierung (der Isolation zur Umgebung) auch eine Funktionsisolierung (Isolierung verschiedener Bereiche auf einer strukturierten und mit Bauelementen versehenen Fläche) bereitstellen.

Die Definitionen der verwendeten Fachbegriffe finden sich in "Kapitel 1 bei König, Rao, Teilentladungen in Betriebsmitteln der Energietechnik, VDE- Verlag 1993 ISBN 3-8007-1764-6".

Leistungshalbleitermodule, die Ausgangspunkt dieser Erfindung sind, sind hinlänglich bekannt. Aus der DE 196 51 632 sind Leistungshalbleitermodule mit keramischen Substraten sowie einer Grundplatte bekannt, aus der EP 0 750 345 sowie der DE 197 00 963 sind Leistungshalbleitermodule mit keramischen Substraten ohne Grundplatte bekannt, druckkontaktierte Aufbauten mit keramischen Substraten sind aus der DE 43 10 466 bekannt. Bekannt ist auch beispielhaft aus der US 5,466,969, dass zusätzliche Bauelemente, wie Sensoren und / oder Ansteuerschaltungen, in das Leistungsmodul integriert sind.

All diesen Ausgestaltungen von Leistungshalbleitermodulen nach dem Stand der Technik ist gemeinsam die Verwendung eines beidseitig metallkaschierten keramischen Substrats, hergestellt z.B. durch eine Spinellbindung zwischen Aluminiumoxid ($Al_2O_3$) und Kupferoxid nach dem "Direct Copper Bonding" (DCB)- Verfahren beispielsweise nach EP 0 627 760 oder durch ein Aktivlötverfahren "Active Metal Brazing" (AMB). Neben Kupfer sind grundsätzlich auch Aluminium oder Silber als Metallisierungen denkbar. In Verbindung mit Aluminiumnitrit (AIN) als Keramikmaterial sind auch Verfahren in der Entwicklung, bei denen durch einen Sinterprozess eine Aluminium- Schicht auf das Keramikmaterial aufgebracht wird. Dabei kann auch nachträglich auf diese Aluminium- Schicht eine weitere Metallschicht, z.B. aus Kupfer, abgeschieden werden.

Weiterhin typisch für derartige Leistungshalbleitermodule ist eine Verfüllung z.B. mit einem Monomer des Silikonkautschuks, der nach Entgasen polymerisiert wird. Durch diesen Silikonkautschuk wird die Isolierung sichergestellt.

Bei allen bekannten Ausgestaltungen dieser Substrate ist die metallisch kaschierte Fläche in ihrer Ausdehnung kleiner als die Fläche der Keramik, dadurch ergibt sich in den Randbereichen der Substrate eine nicht kaschierte Fläche. Typischerweise ist die Breite dieser Fläche und damit der Abstand des Randes der metallischen Kaschierung zum Rand der Keramik auf der ersten, mit Bauelementen bestückten, dem Kühlkörper bzw. der Grundplatte abgewandten Oberfläche sowie auf der zweiten dem Kühlkörper bzw. der Grundplatte zugewandten Oberfläche identisch. Alternativ besitzt der Rand der Kaschierung der zweiten Oberfläche einen geringeren Abstand vom Rand der Keramik als der der ersten Oberfläche. Dies ist dadurch begründet, dass z.B. in druckkontaktierten Leistungshalbleitermodulen, bei denen ein guter thermischer Kontakt zu einem Kühlkörper vorrangiges Ziel der Entwicklung ist, im Randbereich Druckkräfte auf das Substrat wirken. Um einen Bruch der Keramik zu vermeiden, wird die zweite Kaschierung bis nahe an den Rand der Keramik aufgebracht. Auch bekannt sind aus der US 5,466,969 zusätzliche Ansteuerschaltkreise auf der ersten Oberfläche des Substrats. Hierbei kann unterhalb der für die Ansteuerung verwendeten Fläche auf ein Metallkaschierung verzichtet werden, um eine verringerte kapazitive Kopplung zu erreichen.

Des Weiteren ist aus der EP 0 827 198 bekannt, dass ein zum Substrat hin gestufter Rand der ersten Kaschierung die Zuverlässigkeit für Anwendungen mit höheren Anforderungen verbessert und dadurch die Leistungsmodul-Leiterplatten mindestens 1500 Wärmezyklen abdingen können.

An die Isolationsfestigkeit der Basisisolierung werden im allgemeinen deutlich höhere Anforderungen gestellt als an die Funktionsisolierung. So fordert die IEC 1287 für die Basisisolierung eine Prüfspannung von:

$$U_{iso,rms} = \frac{2 \cdot U_m}{\sqrt{2}} + 1000V$$

wobei $U_m$ die maximale, ständig wiederkehrende Spannung in der Schaltung repräsentiert. Die Spannung $U_{iso,rms}$ ist bei der Prüfung des Bauelements (Leistungshalbleitermoduls) für eine Minute anzulegen. Für die Isolationsfähigkeit der Basisisolierung ist die Ausgestaltung des Randbereiches der Keramik entscheidend.

Der Randbereich des Substrats ist nach dem Stand der Technik derart ausgestaltet, dass die Breite der Fläche zwischen dem Rand der Metallkaschierung der ersten Oberfläche und dem Rand der Keramik gleich oder größer ist als die Breite der Fläche zwischen dem Rand der Metallkaschierung der zweiten Oberflächen und dem Rand der Keramik. Auch in der US 5,466,969 ist der Randbereich des Leistungsteils der Schaltungsanordnung derart gestaltet. Dies hat nachteilige Auswirkungen auf die Isolationsfähigkeit der Basisisolationsfähigkeit des Substrats.

Die Metallkaschierungen der beiden Keramikoberflächen wirken wie ein Plattenkondensator mit der Keramik als Dielektrikum zwischen den Platten. Typischerweise liegt die Metallkaschierung auf einer Grundplatte oder einem Kühlkörper und damit auf einem definierten Bezugspotential. Die verschiedenen Teile der Metallkaschierung der ersten Oberfläche können auf unterschiedlichen Potentialen liegen, speziell für optionale Ansteuerschaltungen oder Sensoren oder Ähnliches liegen deren Metallkaschierungen nach dem Stand der Technik häufig auf Erdpotential. Durch die Anordnung des Leistungshalbleitermoduls auf einem normalerweise metallischen Kühlkörper auf einem Bezugspotential, das nicht zwangsläufig dem Erdpotential entspricht, ergibt sich ein stark inhomogener Feldverlauf des elektrischen Feldes im Außenbereich des Plattenkondensators. Eine hohe Dichte von Äquipotentiallinien repräsentiert dabei einen Bereich hoher Feldstärke. Entscheidend für die Isolationsfähigkeit der Basisisolierung des unkaschierten Randbereiches der Keramik oder des Bereichs zwischen einer auf hohen Potential und einer auf einem anderen Potential liegenden weiteren Metallkaschierung der ersten Oberfläche ist die tangential zu dieser verlaufende Feldstärke direkt an der Oberfläche. Diese Feldstärke wird repräsentiert durch den tangentialen Abstand der Äquipotentiallinien.

Die höchste Äquipotentiallinien- Dichte an der Keramikoberfläche und damit der für die Isolationsfestigkeit der Basisisolierung kritischste Bereich befindet sich an der ersten Oberfläche der Keramik unmittelbar anschließend an die Fläche der Metallkaschierung mit hohem Potential.

Der Einfluss der Gestaltung des Randbereichs eines Substrats hat entscheidenden Einfluss auf die Isolations- und Teilentladungsfestigkeit von Leistungshalbleitermodulen. Dieser Einfluss kommt bei dünnen Keramikschichten stärker zum tragen; bei heute üblichen Keramikdicken von 0,38mm wird dieser Einfluss oberhalb von 5000V dominant.

Mit der Integration der oben genannten Zusatzfunktionen in das Leistungshalbleitermodul wird die Isolation dieser direkt auf dem Substrat befindlichen Bauelemente, wie z.B. Sensoren, zu einem weiteren wichtigen Zuverlässigkeitsmerkmal. Da beispielhaft die Sensorsignale direkt von den Ansteuerschaltungen ausgewertet werden, muss eine elektrische Trennung zwischen Leistungsschaltkreis und dem Sensor sichergestellt werden. Dies wird durch eine Anordnung auf zwei voneinander isolierten Metallkaschierungen erreicht. Innerhalb des Leistungsschaltkreises muss an derartige isolierte Metallkaschierungen untereinander nur eine Funktionsisolierung sichergestellt sein. Gegenüber den Zusatzfunktionen (z.B. Sensoren) muss demgegenüber eine Basisisolierung sichergestellt werden.

Die Forderungen an die Basisisolierung sind im Allgemeinen höher, da je nach Anwendung, wie z.B. die Serienschaltung von Leistungshalbleitermodulen, das Bezugspotential eines einzelnen Leistungshalbleitermoduls nicht identisch mit dem Erdpotential sein muss. Da allerdings aus schaltungstechnischen Gründen meist alle Sensoren einer Serienschaltung von Leistungshalbleitermodulen auf identischem Potential liegen, kann die Potentialdifferenz zwischen dem Leistungsschaltkreis eines Leistungshalbleitermoduls und dem Sensor höher sein als innerhalb des Leistungsschaltkreises. Daher werden zur Prüfung der Isolationsfestigkeit eines Leistungsmoduls mit Sensorelementen oder Zusatzfunktionen zwei Teilprüfungen durchgeführt. In der ersten Teilprüfung wird der Sensor mit dem Funktionsschaltkreis auf ein gemeinsames, hohes Potential gelegt und die Basisisolierung gegenüber der Umgebung geprüft, wobei für den Sensor und die ihm zugehörigen Bereiche der Metallkaschierung die gleichen Anforderungen gelten wie für die Breiche des Funktionsschaltkreises. In der zweiten Teilprüfung wird der Sensor auf dem Umgebungspotential gehalten und nur die Bereiche des Funktionsschaltkreises auf ein hohes Potential gelegt. Hierbei tritt zwischen der Metallisierung der zum Funktionsschaltkreis gehörenden Metallisierung und der zum Sensor gehörenden Bereiche der Metallisierung ein Potentialgefälle auf, daß geeignete Maßnahmen zur Sicherstellung der Basisisolierung notwendig macht. Beide Teilprüfungen zusammen stellen sicher, daß der Sensor auf einem beliebigen Potential zwischen Umgebungspotential und maximal zulässiger Isolationsspannung des Leistungsmoduls betrieben werden kann.

Die sich aus diesen Anforderungen ergebenden Schwierigkeiten werden auch in EP 1 111 970 diskutiert und es wird ein Verfahren zur Verbesserung der Isolationsfestigkeit vorgeschlagen, ohne sich der in dieser Erfindung vorgestellten geometrischen Optimierung zu bedienen.

Der Erfindung liegt die Aufgabe zugrunde die Isolationsfestigkeit der Basisisolierung von Leistungsmodulen, wobei diese auch zusätzlichen auf Erdpotential, oder einem anderen Potential liegenden Metallkaschierungen für Sensoren und / oder Ansteuerschaltungen des Substrats aufweisen können, zu erhöhen und die Teilentladungseigenschaften zu verbessern.

Die Aufgabe wird erfindungsgemäß gelöst durch die Merkmale der Ansprüche 1 und 2. Bevorzugte Ausführungsformen sind in den Unteransprüchen beschrieben.

Im Randbereich von erfindungsgemäßen Leistungshalbleitermodulen wirkt die Grundplatte, bzw. bei grundplattenlosen Modulen der Kühlkörper, als Feldplatte und führt zu einer Reduzierung der Feldstärke auf dem unkaschierten Bereiche der ersten Oberfläche.

Durch die geeignete, größere Wahl des Abstandes des Randes der Metallkaschierung der zweiten Oberfläche zum Rand der Keramik verglichen mit dem Abstand des Randes der Metallkaschierung der ersten Oberfläche zum Rand der Keramik wird die Feldstärke tangential zum Rand speziell im kritischen Bereich unmittelbar anschließend an die Metallkaschierung der ersten Oberfläche verringert. Diese geeignete Wahl wird durch ein Optimierungsverfahren erreicht, bei dem die Tangentialkomponenten der Feldstärke direkt neben der ersten bzw. zweiten Metallisierungskante identische Werte erreichen.

Bei Leistungshalbleitermodulen mit integrierten Zusatzfunktionen wird die Feldstärke tangential zur Oberfläche speziell im kritischen Bereich unmittelbar anschließend an eine benachbart zu einer Metallkaschierung auf niedrigerem Potential liegenden Metallkaschierung auf hohem Potential folgendermaßen verringert. Auf der zweiten Oberfläche der Keramik ist eine metallische Kaschierung derart angeordnet, dass deren Rand gegenüber dem Rand der darüber auf der ersten Oberfläche angeordneten metallischen Kaschierung, die zum elektrischen Schaltkreis gehört und bei der Isolationsprüfung auf ein hohes Potential gelegt wird, derart versetzt ist, dass sich unterhalb des Randbereiches dieser metallischen Kaschierung der ersten Oberfläche ein unkaschierter Bereich ergibt, in den hinein sich die Feldlinien ausdehnen können.

Nachfolgend wird die erfinderische Lösung sowie spezielle Ausgestaltung des erfinderischen Gedankens anhand der Figuren 1 bis 9 näher erläutert.

Fig. 1 zeigt die für die Erfindung wichtigen geometrischen Verhältnisse des Randbereiches eines Substrats für Leistungshalbleitermodule.

Fig. 2 zeigt die für die Erfindung wichtigen geometrischen Verhältnisse eines Substrats für Leistungshalbleitermodule mit Zusatzfunktionen.

Fig. 3. zeigt den Randbereich eines Substrats für Leistungshalbleitermodule nach dem Stand der Technik

Fig. 4. zeigt eine erfinderische Ausgestaltung des Randbereich eines Substrats für Leistungshalbleitermodule.

Fig. 5. zeigt den Randbereich eines Substrats für Leistungshalbleitermodule mit Zusatzfunktionen nach dem Stand der Technik

Fig. 6. zeigt eine erfinderische Ausgestaltung des Randbereich eines Substrats für Leistungshalbleitermodule mit Zusatzfunktionen.

Fig. 7. zeigt die Ergebnisse des erfinderischen Gedankens anhand eines Optimierungsbeispiels des Randbereiches von Leistungshalbleitermodule.

Fig. 8. zeigt die Ergebnisse des erfinderischen Gedankens anhand eines Optimierungsbeispiels für Substrate von Leistungshalbleitermodule mit Zusatzfunktionen.

Fig. 9 zeigt eine weitere Ausgestaltung eines erfinderischen Substrats für Leistungshalbleitermodule.

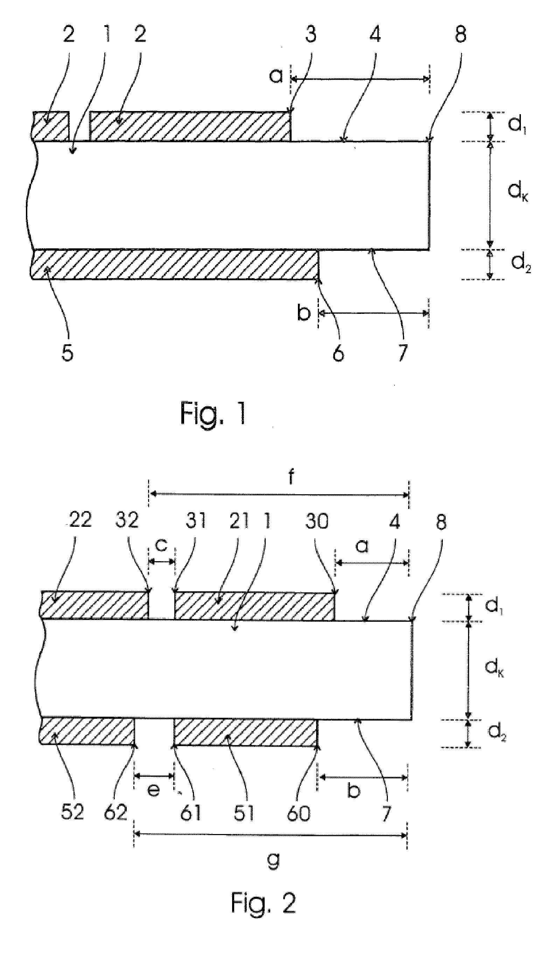

Fig. 1 zeigt die für die Erfindung wichtigen geometrischen Verhältnisse des Randbereiches eines Substrats für Leistungshalbleiterbauelemente. Das Substrat besteht aus einer keramischen Schicht (1) der Dicke $d_K$, die mit einer Metallkaschierung (2) der Dicke $d_1$ auf der ersten Oberfläche (4) der Keramik (1) und einer Metallkaschierung (5) der Dicke $d_2$ auf der zweiten Oberfläche (7) der Keramik (1). Die Metallkaschierung (2) dient als Träger der Leistungsschaltung und ist daher meist in sich strukturiert. Die Metallkaschierung (5) ist entweder mit einer Grundplatte verbunden oder direkt mit einem Kühlkörper in Kontakt und weist in der Regel keine innere Strukturierung auf.

Der Randbereich der Keramik (1) weist typischerweise keine metallische Kaschierung auf. Dieser unkaschierte Bereich hat auf der ersten Oberfläche (4) eine Breite a, dies ist der Abstand des Randes der metallischen Kaschierung (2) zum Rand (8) der Keramik, sowie auf der Oberfläche (7) eine Breite b entsprechend dem Abstand des Randes der zweiten metallischen Kaschierung (5) zum Rand (8) der Keramik. Nach dem Stand der Technik ist entweder a = b oder a > b.

Fig. 2 zeigt die für die Erfindung wichtigen geometrischen Verhältnisse eines Substrats für Leistungshalbleiterbauelemente mit Zusatzfunktionen. Das Substrat besteht ebenfalls aus einer keramischen Schicht (1) der Dicke $d_K$, worauf eine Metallkaschierung (21, 22) der Dicke $d_1$ auf der ersten Oberfläche (4) der Keramik (1) und mindestens einer Metallkaschierung (52) der Dicke $d_2$ auf der zweiten Oberfläche (7) der Keramik (1) angeordnet sind. Die Metallkaschierung (22) dient als Träger der Leistungsschaltung und ist daher meist in sich weiter strukturiert. Eine weitere, zweite Metallkaschierung (21) dient der Aufnahme zusätzlicher Funktionseinheiten, wie Sensoren und / oder Ansteuerschaltung, und liegt in der Regel auf dem Potential einer Grundplatte oder eines Kühlkörpers oder auf einem anderen beliebigen Potential, wie es z.B. bei der Reihenschaltung von Leistungshalbleitermodulen üblich ist. Die Metallkaschierungen (51, 52) sind entweder mit der Grundplatte verbunden oder direkt mit dem Kühlkörper in Kontakt.

Der Randbereich der Keramik (1) weist typischerweise keine metallische Kaschierung auf. Dieser unkaschierte Bereich hat auf der ersten Oberfläche (4) eine Breite a, dies ist der Abstand des Randes der weiteren metallischen Kaschierung (21) bzw. deren Rand (30) zum Rand (8) der Keramik. Die auf hohem Potential liegende erste Metallkaschierung (22) bzw. deren Rand (32) weist vom ihr zugewandten Rand (31) der weiteren zweiten Metallkaschierung (21) einen Abstand c auf. Der gesamte Abstand der ersten Metallkaschierung (22) bzw. deren Rand (32) vom Rand (8) des Substrats (1) besitzt die Breite f. Die zweite Oberfläche (7) der Keramik (1) weist mindestens eine metallische Kaschierung (52) auf, deren Rand (62) vom Rand (8) des Substrats den Abstand g besitzt. Die zweite Oberfläche (7) der Keramik (1) kann eine weitere metallische Kaschierung (51) aufweisen, die zwischen der metallischen Kaschierung (52) und dem Rand (8) des Substrats (1) angeordnet ist. Deren Rand (60) besitzt eine Abstand b vom Rand (8) des Substrats sowie einen Abstand e vom Rand der Metallkaschierung (52). Typisch ist ein identischer Abstand des Randes (61) dieser Kaschierung (51) sowie des Randes (31) der weiteren Kaschierung (21) auf der ersten Oberfläche (4) vom Rand des Substrats (8). Nach dem Stand der Technik ist entweder f = g oder f > g.

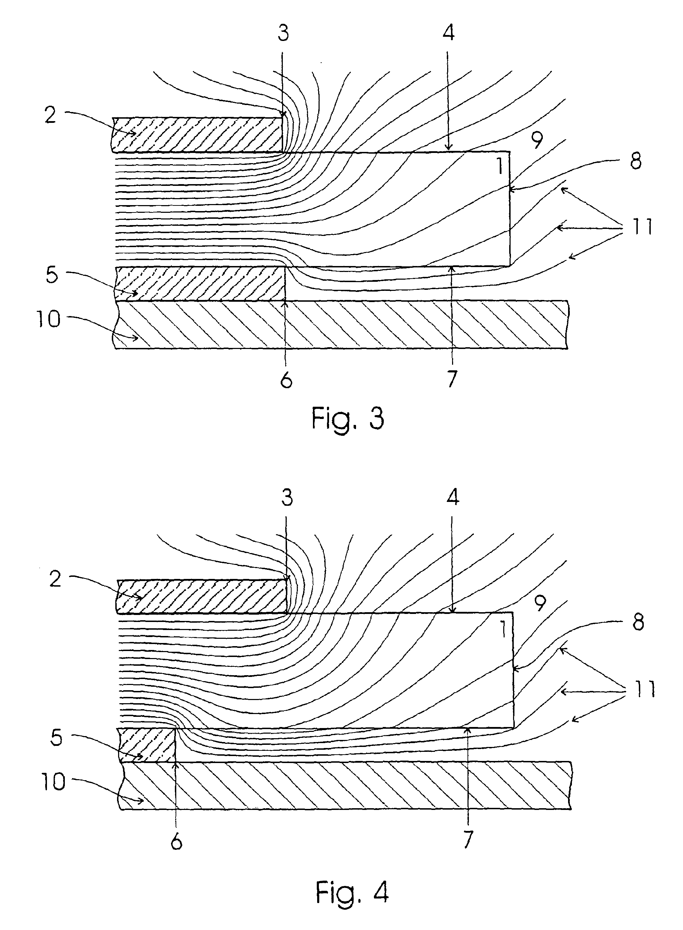

Für die Berechnung der Äquipotentiallinien bzw. der Tangentialfeldstärke in den Figuren 3 bis 6 wurden folgende Annahmen zugrunde gelegt:

| Schicht | Material | Dicke | relative Dielektrizitätskonstante $\varepsilon/\varepsilon_0$ |
|---------|----------|-------|------------------------------------------|
| Metallkaschierung (2, 21, 22) der ersten Oberfläche (4) | Kupfer | 0,3 mm | ---- |
| Keramik (1) | Aluminiumnitrit | 1,0 mm | 9,0 |
| Metallkaschierung (5, 51, 52) der zweiten Oberfläche (7) | Kupfer | 0,3 mm | ---- |
| Umgebungsmedium (9) | Silikonkautschuk | ---- | 2,9 |

Das Potential der Metallkaschierungen (2, 22) entspricht 9000 V; das Potential aller weiteren Metallkaschierungen (21, 5, 51, 52) entspricht Erdpotential; der Abstand der Äquipotentiallinien entspricht 530 V.

Fig. 3. zeigt den Randbereich mit den berechneten Äquipotentiallinien (11) nach obigen Annahmen eines Substrats für Leistungshalbleitermodule nach dem Stand der Technik. Der Abstand des Randes beider metallischen Kaschierung (2, 5) zum Rand (8) der Keramik ist gleich (a = b = 2 mm).

Je dichter die Äquipotentiallinien (11) längs eines beliebigen Vektor aufeinander folgen, desto größer ist die Feldstärke längs dieses Vektors. Die höchste Äquipotentiallinien- Dichte direkt an der Oberfläche und tangential zu dieser verlaufend ergibt sich unmittelbar vor der Kante der Metallkaschierung (3). Diese sogenannte "Feldspitze" führt zu einem stark inhomogen Feldstärkeverlauf an der gesamten unkaschierten Oberfläche der Keramik. Mit den Annahmen aus obiger Tabelle ergibt sich im Abstand von 20 $\mu$m neben der Metallisierungskante (3) einen Maximalwert der Tangentialkomponente der Feldstärke von mehr als 25 kV/mm.

Aus dem gezeigten Feldverlauf wird auch deutlich, dass eine gleichzeitige Verbreiterung des Randes auf der ersten sowie auf der zweiten Oberfläche keinen Einfluß auf die Isolationsfestigkeit hat, da die Feldspitze also der Feldverlauf unmittelbar anschließend an den Rand (3) der Metallkaschierung (2) hiervon nicht beeinflusst wird.

Fig. 4. zeigt den erfinderischen Randbereich eines Substrats für Leistungshalbleitermodule mit den berechneten Äquipotentiallinien (11) nach obigen Annahmen. Der Abstand des Randes (3) der metallischen Kaschierung (2) zum Rand (8) der Keramik ist geringer als der Abstand des Randes (6) der metallischen Kaschierung (5) zum Rand (8) der Keramik (a < b; a = 2 mm; b = 3 mm).

Die Reduktion der Tangentialkomponente der Feldstärke direkt neben der Metallisierungskante (3) auf der ersten Oberfläche (4) und die Wirkung der Feldplatte (10) sind hier deutlich zu erkennen, da sich die Äquipotentiallinien (11) bereits in der Keramik (1) noch im Bereich der Metallkaschierung (2) aufweiten und so die Dichte der Äquipotentiallinien an der ersten Oberfläche der Keramik an der Metallisierungskante (3) reduziert wird.

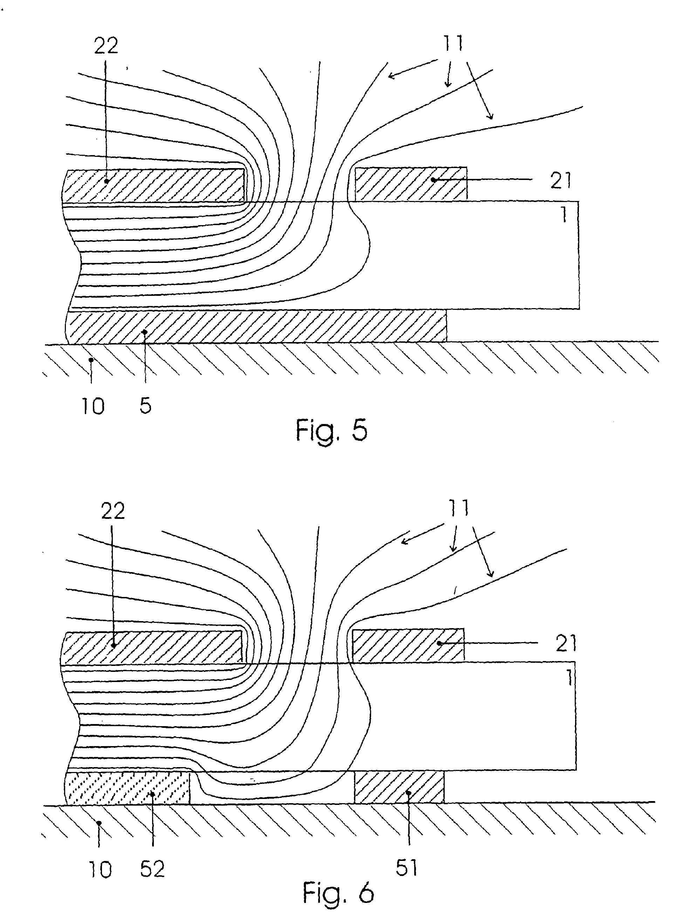

Fig. 5. zeigt den Randbereich mit den berechneten Äquipotentiallinien (11) nach obigen Annahmen eines Substrats für Leistungshalbleitermodule mit Zusatzfunktionen in diesem Randbereich nach dem Stand der Technik. Der Abstand c zwischen dem Rand der auf Erdpotential liegenden metallischen Kaschierung (21) und dem Rand (32) der auf 9000V liegendem Potential der metallischen Kaschierung (22) beträgt 1mm.

Je dichter die Äquipotentiallinien (11) längs eines beliebigen Vektor aufeinander folgen, desto größer ist die Feldstärke längs dieses Vektors. Die höchste Äquipotentiallinien- Dichte direkt an der Oberfläche und tangential zu dieser verlaufend ergibt sich unmittelbar vor der Kante (32) der Metallkaschierung (22). Diese sogenannte Feldspitze führt zu einem stark inhomogenen Feldstärkenverlauf an der gesamten unkaschierten Oberfläche der Breite c = 1mm an der Oberseite (4) der Keramik (1). Im Abstand von 20 $\mu$m neben der Metallisierungskante (32) ergibt sich mit den Annahmen aus obiger Tabelle ein Wert der Tangentialkomponente der Feldstärke von mehr als 29 kV/mm.

Aus dem gezeigten Feldverlauf wird auch deutlich, dass in diesem Fall die Randbreiten a und b keinen Einfluss auf die Isolationsfestigkeit besitzen.

Fig. 6. zeigt den Randbereich eines erfinderischen Substrats eines Leistungshalbleitermodule mit Zusatzfunktionen mit den berechneten Äquipotentiallinien (11) nach obigen Annahmen. Hierbei wurde die einstückige Metallkaschierung (5) aus Fig. 5 unterbrochen und in zwei durch einen Graben der Breite e = 2mm, auf gleichem Potential befindliche Metallkaschierungen (51, 52) ersetzt. Hierbei ist zu beachten, dass bei der Ausgestaltung dieses Grabens die Bedingung g > f erfüllt wird und damit der Rand (32) der Metallkaschierung (22) einen geringern Abstand zum Rand (8) der Keramik (1) aufweist als der Rand (62) der Metallkaschierung (52).

Die Reduktion der Tangentialkomponente der Feldstärke direkt neben der Metallisierungskante (32) und die Wirkung der Feldplatte (10) sind hier deutlich zu erkennen, da sich die Äquipotentiallinien (11) nun in den Bereich zwischen den Kaschierungen (51 und 52) ausdehnen und damit auch im Bereich des Randes (32) der Metallkaschierung (22) eine Aufweitung der Äquipotentiallinien (11) erreicht wird und somit die Dichte der Äquipotentiallinien und damit die Feldstärke an der ersten Oberfläche (4) der Keramik (1) an der Metallisierungskante (32) auf einen Wert von ca. 25,3 kV/mm reduziert wird.

Die metallische Kaschierung (51) kann auch gänzlich entfallen, solange weiterhin die Bedingung g > f erfüllt bleibt. Allerdings ist diese Kaschierung hilfreich, um die mechanische Stabilität des Leistungshalbleitermoduls zu gewährleisten. Ebenso ist sie notwendig zur thermischen Ankopplung an den Kühlköper bei Verwendung eines Temperatursensors.

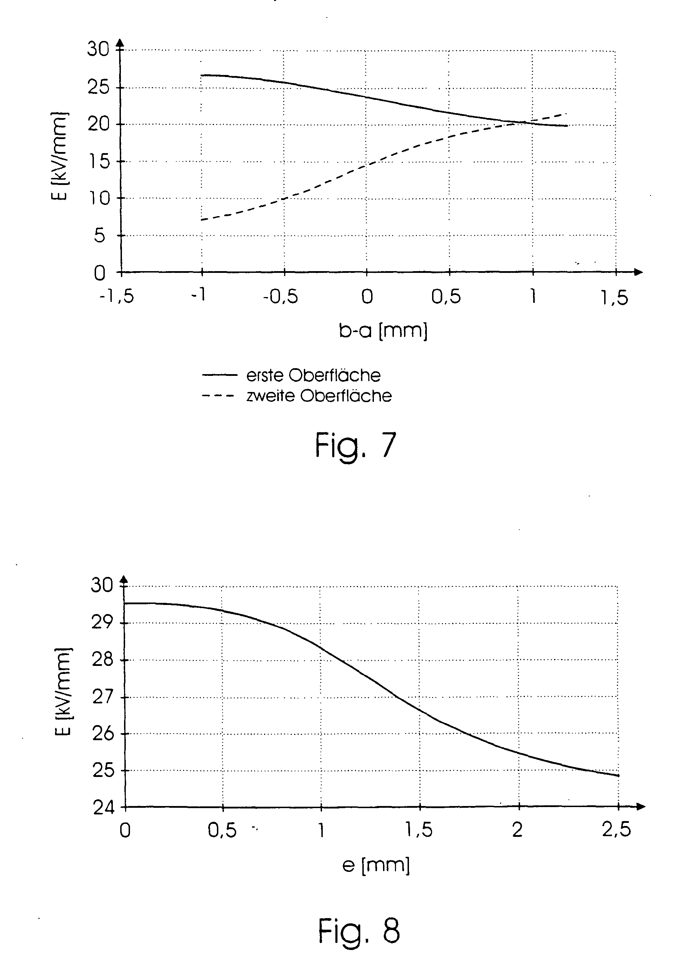

Fig. 7 zeigt die Ergebnisse des erfinderischen Optimierungsverfahrens am Anwendungsbeispiel eines Substrats für Leistungshalbleitermodule nach Fig. 3. Das Optimierungsverfahren zur Suche desjenigen Abstandes b des Randes (6) der metallischen Kaschierung (5), bei gegebenem Abstand a des Randes (3) der metallischen Kaschierung (2), zum Rand (8) der Keramik geht von folgenden Annahmen aus.

Die Tangentialkomponente der elektrischen Feldstärke an der Grenzfläche zwischen der Keramik und dem Umgebungsmedium kann bewegliche elektrische Ladungen beschleunigen. Reicht die während der mittleren freien Weglänge aufgenommene Energie aus, um bei einem Stoß weitere Ionen zu erzeugen, so kommt es zu einem Lawinendurchbruch, der als Randüberschlag zum Zusammenbruch der Isolation führt. Daher gilt es also, die durch die Tangentialkomponente der elektrischen Feldstärke $E_t$ längs der Oberfläche der Keramik auf eine freie Ladung q übertragene Energie W auf der mittleren freien Weglänge $l_{fr}$ zu minimieren:

$$W = q \int_0^{l_{fr}} E_t \cdot ds$$

Da jedoch für reale Anwendungen einerseits die Ränder der Metallkaschierungen keine scharf ausgebildeten Grenzen sind, wird hier nur eine Abschätzung vorgenommen, indem das Maximum der Tangentialkomponente und der lokale Wert der Tangentialkomponente in einem Abstand von 20 $\mu$m vom Metallisierungsrand bestimmt wird.

Durch Verbreiterung des Abstandes b des Randes der metallischen Kaschierung (5) zum Rand (8) der Keramik wird die Feldstärke an der Metallisierungskante (3) der ersten Oberfläche (4) reduziert. Für die zugrunde gelegten Annahmen ergibt das Optimierungsverfahren bei einem Abstand des Randes (3) der metallischen Kaschierung (2) zum Rand (8) der Keramik von a = 2 mm für den Abstand des Randes (6) der metallischen Kaschierung (5) zum Rand (8) der Keramik b = 3 mm.

Bei diesen Werten erreicht die Tangentialkomponente der elektrischen Feldstärke im Abstand von 20 $\mu$m der jeweiligen Metallisierungsränder (3 bzw. 6) den gleichen Wert. Dadurch kann eine Verringerung der Tangentialkomponente der elektrischen Feldstärke in unmittelbarer Nähe zum Metallisierungsrand (3) von etwa 20% gegenüber dem Stand der Technik (Fig. 3) erreicht werden und somit auch die Isolationsfestigkeit der Basisisolierung des gesamten Substrats entsprechend erhöht werden.

Fig. 8. zeigt die Ergebnisse des erfinderischen Optimierungsverfahrens für ein Anwendungsbeispiel nach Fig. 6. Das Optimierungsverfahren zur Suche desjenigen Abstandes e des Randes (62) der metallischen Kaschierung (52) vom Rand (61) der metallischen Kaschierung (51), bei gegebenem Abstand c = 1mm des Randes (32) der metallischen Kaschierung (22) zum Rand (32) der metallischen Kaschierung (21) und unter der Annahme, dass der Rand (31) der Metallkaschierung (21) und der Rand (61) der Metallkaschierung (51) den gleichen Abstand vom Rand (8) der Keramik (1) aufweisen, geht von den gleichen Annahmen wie bei Fig. 7 genannt aus.

Durch Verbreiterung des Abstandes e des Randes (62) der metallischen Kaschierung (52) zum Rand (61) der metallischen Kaschierung (51) wird die Feldstärke an der Metallisierungskante (32) der ersten Oberfläche (4) reduziert. Für die zugrunde gelegten Annahmen ergibt das Berechnungsverfahren für den Abstand des Randes (62) der metallischen Kaschierung (52) zum Rand (61) der metallischen Kaschierung (51) von e = 2mm eine Verringerung der Tangentialfeldstärke um ca. 15% gegenüber dem Stand der Technik. Somit wird auch die Isolationsfestigkeit der Basisisolierung des gesamten Substrats entsprechend erhöht.

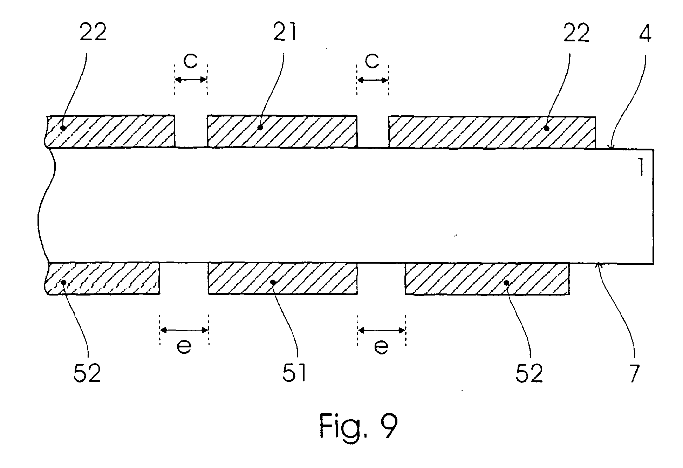

Fig. 9 zeigt eine weitere Ausgestaltung eines erfinderischen Substrats für Leistungshalbleitermodule. Hierbei ist die metallische Kaschierung (21) für einen Sensor von weiteren metallischen Kaschierungen (22) umgeben. Die entsprechenden Metallkaschierungen (52) der zweiten Oberfläche (7) sind entsprechend um den Abstand e — c gegenüber dem Rand der Kaschierungen (22) der ersten Oberfläche (4) zurückversetzt.

**Patentansprüche**

1. Leistungshalbleitermodul mit oder ohne Grundplatte bestehend aus einem Gehäuse, zur Kontaktierung benötigten Anschlusselementen, mindestens einem Halbleiterbauelement sowie einem beidseitig metallkaschierten keramischen Substrat (1), wobei

die metallischen Kaschierungen (21, 22 bzw. 52) die erste (4) bzw. zweite (7) Oberfläche der Keramik (1) nur teilweise bedecken, mindestens eine erste auf der ersten Oberfläche (4) angeordneten metallische Kaschierung (22) mit einem Rand (32) auf höherem Potential gegenüber mindestens einer weiteren benachbart angeordneten metallischen Kaschierung (21) mit den Rändern (30 und 31) liegt und auf der zweiten Oberfläche (7) der Keramik (1) mindestens eine metallische Kaschierung (52) angeordnet ist, deren Rand (62) gegenüber dem Rand (32) der darüber auf der ersten Oberfläche (4) angeordneten ersten metallischen Kaschierung (22) derart versetzt ist, dass sich unterhalb des Randbereiches dieser ersten metallischen Kaschierung (22) der ersten Oberfläche (4) ein unkaschierter Bereich ergibt und dies eine Erhöhung der Isolationsfestigkeit der Basisisolierung des Substrats bewirkt, wobei bei der Ausgestaltung des unkaschierten Bereichs die Bedingung (g > f) erfüllt ist,

wobei (g) der Abstand des Randes (62) der metallischen Kaschierung (52) der zweiten Oberfläche (7) der Keramik (1) vom Rand des Substrats (8) ist

und

wobei (f) der gesamte Abstand der ersten Metallkaschierung (22) bzw. deren Rand (32) vom Rand (8) des Substrats (1) ist.

2. Leistungshalbleitermodul nach Anspruch 1, **dadurch gekennzeichnet, dass**
das keramische Substrat (1) aus Aluminiumoxid, Aluminiumnitrit, Berylliumoxid oder Siliziumnitrit besteht.

3. Leistungshalbleitermodul nach Anspruch 1, **dadurch gekennzeichnet, dass**
die metallische Kaschierung (2, 21, 22, 5, 51, 52) der ersten (4) und der zweiten (7) Oberfläche aus Kupfer, Aluminium oder Silber besteht.

4. Leistungshalbleitermodul nach Anspruch 1, **dadurch gekennzeichnet, dass**
die metallische Kaschierung (2, 21, 22, 5, 51, 52) der ersten (4) und der zweiten (7) Oberfläche aus unterschiedlichen Metallen besteht

5. Leistungshalbleitermodul nach Anspruch 1, **dadurch gekennzeichnet, dass**
die metallische Kaschierung (2, 21, 22, 5, 51, 52) der ersten (4) und der zweiten (7) Oberfläche aus mehreren Metallschichten und unterschiedlichen Metallen besteht.

6. Leistungshalbleitermodul nach Anspruch 1, **dadurch gekennzeichnet, dass**
die metallische Kaschierung (2, 21, 22, 5, 51, 52) auf dem keramischen Substrat (1) durch des Direct Copper Bonding (DCB) Verfahren oder das Active Metal Brazing (AMB) Verfahren hergestellt ist.

7. Leistungshalbleitermodul nach Anspruch 1, **dadurch gekennzeichnet, dass**
auf der zweiten Oberfläche (7) der Keramik (1) eine weitere metallische Kaschierung (51) angeordnet ist, deren Ränder (60, 61) näher am Rand (8) der Keramik (1) angeordnet sind als der Rand (62) der metallischen Kaschierung (62)

**Claims**

1. A power semiconductor module with or without a baseplate consisting of a housing, connections required for purposes of making contact, at least one semiconductor component, and also a ceramic substrate (1) metal-laminated on both sides, wherein

the metal laminations (21, 22 and/or 52) only partially cover the first (4) and/or second (7) surface of the ceramic (1), at least one first metal lamination, (22) arranged on the first surface (4) with an edge (32) is at a higher potential relative to at least one other adjacently arranged metallic lamination (21) with the edges (30 and 31), and on the second surface (7) of the ceramic (1) at least one metallic lamination (52) is arranged, the edge (62) of which is displaced relative to the edge (32) of the first metallic lamination (22) arranged above on the first surface (4), such that underneath the edge region of this first metallic lamination (22) of the first surface (4) a non-laminated region ensues, effecting an increase of the insulation strength of the basic insulation of the substrate, wherein

in the configuration of the non-laminated region the condition (g > f) is fulfilled, wherein

(g) is the distance from the edge (62) of the metallic lamination (52) of the second surface (7) of the ceramic (1) to the edge of the substrate (8) and wherein

(f) is the total distance from the first metal lamination (22), or more particularly its edge (32) to the edge (8) of the substrate (1).

2. The power semiconductor module in accordance with Claim 1,
**characterised in that** the ceramic substrate (1) consists of aluminium oxide, aluminium nitride, beryllium oxide or silicon nitride.

3. The power semiconductor module in accordance with Claim 1,
**characterised in that** the metallic lamination (2, 21, 22, 5, 51, 52) of the first (4) and second (7) surfaces consists of copper, aluminium, or silver.

4. The power semiconductor module in accordance with Claim 1,
**characterised in that** the metallic lamination (2, 21, 22, 5, 51, 52) of the first (4) and second (7) surfaces consists of different metals.

5. The power semiconductor module in accordance with Claim 1,
**characterised in that** the metallic lamination (2, 21, 22, 5, 51, 52) of the first (4) and second (7) surfaces consists of a plurality of metal layers and different metals.

6. The power semiconductor module in accordance with Claim 1,
**characterised in that** the metallic lamination (2, 21, 22, 5, 51, 52) on the ceramic substrate (1) is manufactured by the direct copper bonding (DCB) method or the active metal brazing (AMB) method.

7. The power semiconductor module in accordance with Claim 1,
**characterised in that** on the first surface (7) of the ceramic (1) a further metallic lamination (51) is arranged, whose edges (60, 61) are arranged nearer to the edge (8) of the ceramic (1) than the edge (62) of the metallic lamination (62).

## Revendications

1. Module à semi-conducteurs de puissance avec ou sans plaque de base comprenant un boîtier, pour la mise en contact avec des éléments de raccordement nécessaires, au moins un composant à semi-conducteurs et un substrat (1) céramique, plaqué avec du métal des deux côtés, les placages métalliques (21, 22 et 52) recouvrant seulement partiellement la première surface (4) ou la deuxième surface (7) de la céramique (1), au moins un premier placage (22) métallique disposé sur la première surface étant situé avec un bord (32) sur un potentiel supérieur par rapport à au moins un autre placage (21) métallique disposé à proximité avec les bords (30 et 31) et au moins un placage (52) métallique étant disposé sur la seconde surface (7) de la céramique (1), placage dont le bord (62) est décalé par rapport au bord (32) du premier placage (22) métallique disposé au-dessus sur la première surface (4), de telle sorte qu'on obtient une zone non plaquée au-dessous de la zone de bordure de ce premier placage (22) métallique de la première surface (4) et que ceci entraîne une élévation de la résistance à l'isolation de l'isolation de base du substrat, la condition (g > f) étant remplie lors de la conception de la zone non plaquée, (g) étant la distance du bord (62) du placage (52) métallique de la seconde surface (7) de la céramique (1) au bord du substrat (8) et

(f) étant la distance globale du premier placage (22) métallique ou de son bord (32) au bord (8) du substrat (1).

2. Module à semi-conducteurs de puissance selon la revendication 1, **caractérisé en ce que**
le substrat (1) céramique est à base d'oxyde d'aluminium, de nitrite d'aluminium, d'oxyde de béryllium ou de nitrite de silicium.

3. Module à semi-conducteurs de puissance selon la revendication 1, **caractérisé en ce que**
le placage (2, 21, 22, 5, 51, 52) métallique de la première surface (4) et de la seconde surface (7) est à base de cuivre, d'aluminium ou d'argent.

4. Module à semi-conducteurs de puissance selon la revendication 1, **caractérisé en ce que**
le placage (2, 21, 22, 5, 51, 52) métallique de la première surface (4) et de la seconde surface (7) est à base de métaux différents.

5. Module à semi-conducteurs de puissance selon la revendication 1, **caractérisé en ce que**
le placage (2, 21, 22, 5, 51, 52) métallique de la première surface (4) et de la seconde surface (7) est à base de plusieurs couches de métal et de différents métaux.

6. Module à semi-conducteurs de puissance selon la revendication 1, **caractérisé en ce que**
le placage (2, 21, 22, 5, 51, 52) métallique sur le substrat (1) céramique est fabriqué par le procédé Direct Copper Bonding (DCB) ou le procédé Active Metal Brazing (AMB).

7. Module à semi-conducteurs de puissance selon la revendication 1, **caractérisé en ce que**
un autre placage (51) métallique est disposé sur la seconde surface (7) de la céramique (1), placage dont les bords (60, 61) sont disposés plus près du bord (8) de la céramique (1) que le bord (62) du placage (62) métallique.

Fig. 1

Fig. 2

Fig. 3

Fig. 4

Fig. 5

Fig. 6

Fig. 7

Fig. 8

22    21                    22    4

c          c

52        51        52        7

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19651632
- EP 0750345 A
- DE 19700963
- DE 4310466
- US 5466969 A
- EP 0627760 A
- EP 0827198 A
- EP 1111970 A